# EUROPEAN PATENT APPLICATION

(11) **EP 3 171 413 A1**
(43) Date of publication of application: **24.05.2017**
(21) Application number: 16199419.9
(22) Date of filing: 17.11.2016
(51) Int. Cl.: H01L 31/0687, H01L 31/054, H01L 31/0352

(54) **INVERTED METAMORPHIC MULTIJUNCTION SOLAR CELL**

(30) Priority: 20.11.2015 US 201562258240 P
(71) Applicant: SolAero Technologies Corp., Albuquerque, NM 87123 (US)
(72) Inventor: DERKACS, Daniel, Albuquerque, NM 87111 (US); STAN, Marc, Albuquerque, NM 87122 (US); PANTHA, Bed, Albuquerque, NM 87111 (US)
(74) Representative: Balder IP Law, S.L.

(57) **Abstract**

A multijunction solar cell which includes: an upper first solar subcell having a first band gap; a second solar subcell adjacent to said upper first solar subcell and having a second band gap smaller than said first band gap; a third solar subcell adjacent to said second solar subcell and having a third band gap smaller than said second band gap; a graded interlayer adjacent to said third solar subcell, said graded interlayer having a fourth band gap greater than said third band gap; and at least a fourth solar subcell adjacent to said graded interlayer, said fourth solar subcell having a fifth band gap smaller than said third band gap such that said lower fourth solar subcell is lattice mismatched with respect to said third solar subcell.

## Description

### BACKGROUND OF THE INVENTION

### Field of the Invention

The present disclosure relates to solar cells and the fabrication of solar cells, and more particularly the design and specification of a multijunction solar cell.

### Description of the Related Art

Solar power from photovoltaic cells, also called solar cells, has been predominantly provided by silicon semiconductor technology. In the past several years, however, high-volume manufacturing of III-V compound semiconductor multijunction solar cells for space applications has accelerated the development of such technology not only for use in space but also for terrestrial solar power applications. Compared to silicon, III-V compound semiconductor multijunction devices have greater energy conversion efficiencies and generally more radiation resistance, although they tend to be more complex to properly specify and manufacture. Typical commercial III-V compound semiconductor multijunction solar cells have energy efficiencies that exceed 27% under one sun, air mass 0 (AM0), illumination, whereas even the most efficient silicon technologies generally reach only about 18% efficiency under comparable conditions. The higher conversion efficiency of III-V compound semiconductor solar cells compared to silicon solar cells is in part based on the ability to achieve spectral splitting of the incident radiation through the use of a plurality of photovoltaic regions with different band gap energies, and accumulating the current from each of the regions.

In satellite and other space related applications, the size, mass and cost of a satellite power system are dependent on the power and energy conversion efficiency of the solar cells used. Putting it another way, the size of the payload and the availability of on-board services are proportional to the amount of power provided. Thus, as payloads become more sophisticated, and applications anticipated for five, ten, twenty or more years, the power-to-weight ratio and lifetime efficiency of a solar cell becomes increasingly more important, and there is increasing interest not only the amount of power provided at initial deployment, but over the entire service life of the satellite system, or in terms of a design specification, the amount of power provided at the "end of life" (EOL).

The efficiency of energy conversion, which converts solar energy (or photons) to electrical energy, depends on various factors such as the design of solar cell structures, the choice of semiconductor materials, and the thickness of each cell. In short, the energy conversion efficiency for each solar cell is dependent on the optimum utilization of the available sunlight across the solar spectrum as well as the "age" of the solar cell, i.e. the length of time it has been deployed and subject to degradation associated with the space environment. As such, the characteristic of sunlight absorption in semiconductor material, also known as photovoltaic properties, is critical to determine the most efficient semiconductor to achieve the optimum energy conversion to meet customer requirements.

The energy conversion efficiency of multijunction solar cells is affected by such factors as the number of subcells, the thickness of each subcell, the composition and doping of each active layer in a subcell, and the consequential band structure, electron energy levels, conduction, and absorption of each subcell, as well as the effect of its exposure to radiation in the ambient environment over time. The identification and specification of such design parameters is a non-trivial engineering undertaking, and would vary depending upon the specific space mission and customer design requirements. Since the power output is a function of both the voltage and the current produced by a subcell, a simplistic view may seek to maximize both parameters in a subcell by increasing a constituent element, or the doping level, to achieve that effect. However, in reality, changing a material parameter that increases the voltage may result in a decrease in current, and therefore a lower power output. Such material design parameters are interdependent and interact in complex and often unpredictable ways, and for that reason are not "result effective" variables that those skilled in the art confronted with complex design specifications and practical operational considerations can easily adjust to optimize performance. Electrical properties such as the short circuit current density (J_{sc}), the open circuit voltage (V_{oc}), and the fill factor (FF), which determine the efficiency and power output of the solar cell, are affected by the slightest change in such design variables, and as noted above, to further complicate the calculus, such variables and resulting properties also vary, in a non-uniform manner, over time (i.e. during the operational life of the system).

One of the important mechanical or structural considerations in the choice of semiconductor layers for a solar cell is the desirability of the adjacent layers of semiconductor materials in the solar cell, i.e. each layer of crystalline semiconductor material that is deposited and grown to form a solar subcell, have similar crystal lattice constants or parameters. The present application is directed to solar cells with several substantially lattice matched subcells, but including at least two subcells which is lattice mismatched, and in a particular embodiment to a five or a six junction (5J) or (6J) solar cell using III-V semiconductor compounds and two metamorphic layers.

### SUMMARY

All ranges of numerical parameters set forth in this disclosure are to be understood to encompass any and all subranges or "intermediate generalizations" subsumed herein. For example, a stated range of "1.0 to 2.0 eV" for a band gap value should be considered to include any and all subranges beginning with a minimum value of 1.0 eV or more and ending with a maximum value of 2.0 eV or less, e.g., 1.0 to 2.0, or 1.3 to 1.4, or 1.5 to 1.9 eV.

In one aspect, the present disclosure provides a multijunction solar cell. In one embodiment, the multijunction solar cell comprises: an upper first solar subcell having a first band gap in the range of 1.92 to 2.2 eV; a second solar subcell adjacent to said first solar subcell and having a second band gap in the range of 1.65 to 1.78 eV; a third solar subcell adjacent to said second solar subcell and having a third band gap in the range of 1.40 to 1.50 eV; a first graded interlayer adjacent to said third solar subcell; said first graded interlayer having a fourth band gap greater than said third band gap; and a fourth solar subcell adjacent to said first graded interlayer, said fourth subcell having a fifth band gap in the range of 1.05 to 1.15 eV such that said fourth subcell is lattice mismatched with respect to said third subcell; a second graded interlayer adjacent to said fourth solar subcell; said second graded interlayer having a sixth band gap greater than said fifth band gap; and a lower fifth solar subcell adjacent to said second graded interlayer, said lower fifth subcell having a seventh band gap in the range of 0.8 to 0.9 eV such that said fourth subcell is lattice mismatched with respect to said fourth subcell.

In another aspect, the present disclosure provides a method of manufacturing a solar cell. In one embodiment, the method comprises: providing a first substrate; depositing on the first substrate a first sequence of layers of semiconductor material forming a first solar subcell, a second solar subcell, and a third solar subcell; depositing on said third solar subcell a first grading interlayer; depositing on said first grading interlayer a second sequence of layers of semiconductor material forming a fourth solar subcell, the fourth solar subcell being lattice mismatched to the third solar subcell; depositing on said fourth solar subcell a second grading interlayer; depositing on said second grading interlayer a third sequence of layers of semiconductor material forming a fifth solar subcell, the fifth solar subcell being lattice mismatched to the third solar subcell; mounting and bonding a surrogate substrate on top of the sequence of layers; and removing the first substrate.

In one or more embodiments, the first graded interlayer may be compositionally graded to lattice match the third solar subcell on one side and the fourth solar subcell on the other side.

In one or more embodiments, the second graded interlayer may be compositionally graded to lattice match the fourth solar subcell on one side and the fifth solar subcell on the other side.

In one or more embodiments, the first and/or second graded interlayer may be composed of any of the As, P, N, Sb based III - V compound semiconductors subject to the constraints of having the in-plane lattice parameter greater than or equal to that of the third solar subcell and less than or equal to that of the fourth solar subcell, and may have a band gap energy greater than that of the third solar subcell and of the fourth solar subcell.

In one or more embodiments, the first and/or second graded interlayer may be composed of (InₓGa₁₋ₓ)_{y}Al_{1-y}As with 0 < x < 1, 0 < y < 1, and x and y selected such that the band gap remains constant throughout its thickness.

In one or more embodiments, the band gap of the first graded interlayer may remain at a constant value in the range of 1.42 to 1.60 eV throughout its thickness.

In one or more embodiments, the band gap of the second graded interlayer may remain constant at a value in the range of 1.2 to 1.6 eV throughout its thickness.

In one or more embodiments, the upper first subcell may be composed of an AlInGaP or InGaP emitter layer and an AlInGaP base layer, the second subcell may be composed of InGaP emitter layer and a AlGaAs base layer, the third subcell may be composed of an InGaP or GaAs emitter layer and an GaAs base layer, and the bottom fourth subcell may be composed of an InGaAs base layer and an InGaAs emitter layer lattice matched to the base.

In one or more embodiments, lower fifth subcell having a seventh band gap in the range of 0.8 to 0.9 eV, the fourth solar subcell may have a band gap in the range of approximately 1.05 to 1.15 eV, the third solar subcell may have a band gap in the range of approximately 1.40 to 1.42 eV, the second solar subcell may have a band gap in the range of approximately 1.65 to 1.78 eV and the first solar subcell may have a band gap in the range of 1.92 to 2.2 eV.

In one or more embodiments, lower fifth subcell having a seventh band gap in the range of 0.8 to 0.9 eV, the fourth solar subcell may have a band gap of approximately 1.10 eV, the third solar subcell may have a band gap in the range of 1.40 - 1.42 eV, the second solar subcell may have a band gap of approximately 1.73 eV and the first solar subcell may have a band gap of approximately 2.10 eV.

In one or more embodiments, the first solar subcell may be composed of AlGaInP, the second solar subcell may be composed of an InGaP emitter layer and a AIGaAs base layer, the third solar subcell may be composed of GaAs or InₓGaAs (with the value of x in Inₓ between 0 and 1%), and the fourth solar subcell may be composed of InGaAs, and the fifth solar subcell composed of InₓGaAs with the Indium content between 40% (with a band gap of 0.90 eV) to 48.6% (with a band gap of 0.80 eV).

In another aspect, the present disclosure provides a six junction solar cell comprising: an upper first solar subcell having a first band gap in the range of 1.92 to 2.2 eV; a second solar subcell adjacent to said first solar subcell and having a second band gap in the range of 1.65 to 1.78 eV; a third solar subcell adjacent to said second solar subcell and having a third band gap in the range of 1.40 to 1.50 eV; a first graded interlayer adjacent to said third solar subcell; said first graded interlayer having a fourth band gap greater than said third band gap; a fourth solar subcell adjacent to said first graded interlayer, said fourth subcell having a fifth band gap in the range of 1.05 to 1.15 eV and less than that of the third solar subcell such that said fourth subcell is lattice mismatched with respect to said third subcell; a second graded interlayer adjacent to said fourth solar subcell; said second graded interlayer having a sixth band gap greater than said fifth band gap; a fifth solar subcell adjacent to said second graded interlayer, said fifth subcell having a seventh band gap in the range of 0.8 to 0.9 eV such that said fifth subcell is lattice mismatched with respect to said fourth subcell; a third graded interlayer adjacent to said fifth solar subcell; said third graded interlayer having an eighth band gap greater than said seventh band gap; and a lower sixth solar subcell adjacent to said third graded interlayer, said lower sixth subcell having a ninth band gap in the range of 0.6 to 0.75 eV such that said sixth subcell is lattice mismatched with respect to said fifth subcell.

In some embodiments, additional layer(s) may be added or deleted in the cell structure without departing from the scope of the present disclosure.

Some implementations of the present disclosure may incorporate or implement fewer of the aspects and features noted in the foregoing summaries.

Additional aspects, advantages, and novel features of the present disclosure will become apparent to those skilled in the art from this disclosure, including the following detailed description as well as by practice of the disclosure. While the disclosure is described below with reference to preferred embodiments, it should be understood that the disclosure is not limited thereto. Those of ordinary skill in the art having access to the teaching herein will recognize additional applications, modifications and embodiments in other fields, which are within the scope of the disclosure as disclosed and claimed herein and with respect to which the disclosure could be of utility.

### BRIEF DESCRIPTION OF THE DRAWING

The apparatus and methods described herein will be better and more fully appreciated by reference to the following detailed description when considered in conjunction with the accompanying drawings, wherein:
FIG. 1 is a cross-sectional view of a solar cell after an initial stage of fabrication including the deposition of certain semiconductor layers on the growth substrate;
FIG. 2A is a cross-sectional view of a first embodiment of the solar cell of FIG. 1 that includes one distributed Bragg reflector (DBR) layer after the next sequence of process steps;
FIG. 2B is a cross-sectional view of a second embodiment of the solar cell of FIG. 1 that includes one distributed Bragg reflector (DBR) layer after the next sequence of process steps;
FIG. 3A is a cross-sectional view of a first embodiment of the solar cell of FIG. 1 that includes two distributed Bragg reflector (DBR) layers after the next sequence of process steps;
FIG. 3B is a cross-sectional view of a second embodiment of the solar cell of FIG. 1 that includes two distributed Bragg reflector (DBR) layers after the next sequence of process steps; and
FIG. 4 is a graph of the doping profile in the base and emitter layers of a subcell in the solar cell according to the present disclosure.

### DESCRIPTION OF THE PREFERRED EMBODIMENTS

Details of the present disclosure will now be described including exemplary aspects and embodiments thereof. Referring to the drawings and the following description, like reference numbers are used to identify like or functionally similar elements, and are intended to illustrate major features of exemplary embodiments in a highly simplified diagrammatic manner. Moreover, the drawings are not intended to depict every feature of the actual embodiment nor the relative dimensions of the depicted elements, and are not drawn to scale.

The present disclosure describes a process for the fabrication of multijunction solar cells that, in some instances, improve light capture in the associated subcell and thereby the overall efficiency of the solar cell. More specifically, the present disclosure describes a relatively simple and reproducible technique that is suitable for use in a high volume production environment in which various semiconductor layers are deposited in an MOCVD reactor, and subsequent processing steps are defined and selected to minimize any physical damage to the quality of the deposited layers, thereby ensuring a relatively high yield of operable solar cells meeting specifications at the conclusion of the fabrication processes.

Prior to describing the specific embodiments of the present disclosure, a brief discussion of some of the issues associated with the design of multijunction solar cells, and in particular inverted metamorphic solar cells, and the context of the composition or deposition of various specific layers in embodiments of the product as specified and defined by the Applicant is in order.

There are a multitude of properties that should be considered in specifying and selecting the composition of, inter alia, a specific semiconductor layer, the back metal layer, the adhesive or bonding material, or the composition of the supporting material for mounting a solar cell thereon. For example, some of the properties that should be considered when selecting a particular layer or material are electrical properties (e.g. conductivity), optical properties (e.g., band gap, absorbance and reflectance), structural properties (e.g., thickness, strength, flexibility, Young's modulus, etc.), chemical properties (e.g., growth rates, the "sticking coefficient" or ability of one layer to adhere to another, stability of dopants and constituent materials with respect to adjacent layers and subsequent processes, etc. ), thermal properties (e.g., thermal stability under temperature changes, coefficient of thermal expansion), and manufacturability (e.g., availability of materials, process complexity, process variability and tolerances, reproducibility of results over high volume, reliability and quality control issues).

In view of the trade-offs among these properties, it is not always evident that the selection of a material based on one of its characteristic properties is always or typically "the best" or "optimum" from a commercial standpoint or for Applicant's purposes. For example, theoretical studies may suggest the use of a quaternary material with a certain band gap for a particular subcell would be the optimum choice for that subcell layer based on fundamental semiconductor physics. As an example, the teachings of academic papers and related proposals for the design of very high efficiency (over 40%) solar cells may therefore suggest that a solar cell designer specify the use of a quaternary material (e.g., InGaAsP) for the active layer of a subcell. A few such devices may actually be fabricated by other researchers, efficiency measurements made, and the results published as an example of the ability of such researchers to advance the progress of science by increasing the demonstrated efficiency of a compound semiconductor multijunction solar cell. Although such experiments and publications are of "academic" interest, from the practical perspective of the Applicants in designing a compound semiconductor multijunction solar cell to be produced in high volume at reasonable cost and subject to manufacturing tolerances and variability inherent in the production processes, such an "optimum" design from an academic perspective is not necessarily the most desirable design in practice, and the teachings of such studies more likely than not point in the wrong direction and lead away from the proper design direction. Stated another way, such references may actually "teach away" from Applicant's research efforts and the ultimate solar cell design proposed by the Applicants.

In view of the foregoing, it is further evident that the identification of one particular constituent element (e.g. indium, or aluminum) in a particular subcell, or the thickness, band gap, doping, or other characteristic of the incorporation of that material in a particular subcell, is not a "result effective variable" that one skilled in the art can simply specify and incrementally adjust to a particular level and thereby increase the efficiency of a solar cell. The efficiency of a solar cell is not a simple linear algebraic equation as a function of the amount of gallium or aluminum or other element in a particular layer. The growth of each of the epitaxial layers of a solar cell in an MOCVD reactor is a non-equilibrium thermodynamic process with dynamically changing spatial and temporal boundary conditions that is not readily or predictably modeled. The formulation and solution of the relevant simultaneous partial differential equations covering such processes are not within the ambit of those of ordinary skill in the art in the field of solar cell design.

Even when it is known that particular variables have an impact on electrical, optical, chemical, thermal or other characteristics, the nature of the impact often cannot be predicted with much accuracy, particularly when the variables interact in complex ways, leading to unexpected results and unintended consequences. Thus, significant trial and error, which may include the fabrication and evaluative testing of many prototype devices, often over a period of time of months if not years, is required to determine whether a proposed structure with layers of particular compositions, actually will operate as intended, let alone whether it can be fabricated in a reproducible high volume manner within the manufacturing tolerances and variability inherent in the production process, and necessary for the design of a commercially viable device.

Furthermore, as in the case here, where multiple variables interact in unpredictable ways, the proper choice of the combination of variables can produce new and unexpected results, and constitute an "inventive step".

The growth processes for the solar cells described here can use, for example, a MOCVD process in a standard, commercially available reactor suitable for high volume production. The processes can be particularly suitable for producing commercially viable multijunction solar cells or inverted metamorphic multijunction solar cells using commercially available equipment and established high-volume fabrication processes, as contrasted with merely academic expositions of laboratory or experimental results.

Layers of a certain target composition in a semiconductor structure grown in an MOCVD process are inherently physically different than the layers of an identical target composition grown by another process, e.g. Molecular Beam Epitaxy (MBE). The material quality (i.e., morphology, stoichiometry, number and location of lattice traps, impurities, and other lattice defects) of an epitaxial layer in a semiconductor structure is different depending upon the process used to grow the layer, as well as the process parameters associated with the growth. MOCVD is inherently a chemical reaction process, while MBE is a physical deposition process. The chemicals used in the MOCVD process are present in the MOCVD reactor and interact with the wafers in the reactor, and affect the composition, doping, and other physical, optical and electrical characteristics of the material. For example, the precursor gases used in an MOCVD reactor (e.g. hydrogen) are incorporated into the resulting processed wafer material, and have certain identifiable electro-optical consequences which are more advantageous in certain specific applications of the semiconductor structure, such as in photoelectric conversion in structures designed as solar cells. Such high order effects of processing technology do result in relatively minute but actually observable differences in the material quality grown or deposited according to one process technique compared to another. Thus, devices fabricated at least in part using an MOCVD reactor or using a MOCVD process have inherent different physical material characteristics, which may have an advantageous effect over the identical target material deposited using alternative processes.

In some cases, the solar cell according to the present application and present disclosure can provide increased photoconversion efficiency in a multijunction solar cell for outer space or other applications over the operational life of the photovoltaic power system.

A 33% efficient quadruple-junction InGaP₂/GaAs/In_{0.30}Ga_{0.70}As/In_{0.60}Ga_{0.40}As (with band gaps 1.91 eV / 1.42 eV / 1.03 eV / 0.70 eV, respectively) inverted metamorphic multijunction cell may be 10% (relative) more efficient at beginning of life (BOL) than standard ZTJ triple-junction devices and have 40% lower mass when permanently bonded to a 150 um thick low-mass rigid substrate. Further, inverted metamorphic technology may extend the choice of materials that can be integrated together by making possible simultaneous realization of high quality materials that are both lattice-matched to the substrate (InGaP and GaAs, grown first) and lattice-mismatched (In_{0.30}Ga_{0.70}As and In_{0.60}Ga_{0.40}As). The advantage of a metamorphic approach may be that a wide range of infrared bandgaps may be accessed via InGaAs subcells grown atop optically transparent step graded buffer layers. Further, metamorphic materials may offer near-perfect quantum efficiencies, favorably low E_{g}/q - V_{oc} offsets, and high efficiencies. As may often be the case though, efficiency gains may rarely materialize without additional costs. For example, a quadruple-junction (or "4J") inverted metamorphic multijunction cell may be more costly than a ZTJ due to thicker epitaxy and more complicated processing. Further, an inverted epitaxial foil may be removed from the growth substrate and temporarily or permanently bonded to a rigid substrate right-side-up to complete frontside processing. Still further, the result may be an all-top-contact cell that may be largely indistinguishable from a traditional ZTJ solar cell. Yet despite the quadruple-junction inverted metamorphic multijunction cell being a higher efficiency, lower mass drop-in replacement for ZTJ, the higher specific cost [$/Watt] may discourage customers from adopting new or changing cell technologies.

The inverted metamorphic quadruple-junction AlInGaP/AlGaAs/GaAs/InGaAs (with band gaps 2.1 eV / 1.73 eV / 1.42 eV / 1.10 eV respectively) solar cell, or the five-junction AlInGaP/AlGaAs/GaAs/InGaAs/InGaAs (with band gaps 2.1 eV / 1.73 eV / 1.42 eV / 1.10 eV) according to the present disclosure, is not a design that agrees with the conventional wisdom in that an optimized multijunction cell should have balanced photocurrent generation among all subcells and use the entire solar spectrum including the infrared spectrum from 1200 nm - 2000 nm. In this disclosure, a high bandgap current-matched triple-junction stack may be grown first followed by a lattice-mismatched 1.10 eV InGaAs subcell, which in one embodiment, forms the "bottom" subcell. The inverted InGaAs subcell is subsequently removed from the growth substrate and bonded to a rigid carrier so that the four junction solar cell can then be processed as a normal solar cell.

Despite the beginning of life (BOL) efficiency being lower than the traditional inverted metamorphic quadruple-junction solar cell, when high temperature end of life (hereinafter referred to as "HT-EOL") $/W is used as the design metric, the proposed structure may provide a 10% increase in HT-EOL power and a significant decrease in HT-EOL $/W.

The proposed technology differs from existing art (e.g., U.S. Pat. No. 8,969,712 B2) in that a four junction device is constructed as described in the parent application using three lattice-matched subcells and one lattice-mismatched subcell, and three lattice matched subcells and two lattice-mismatched subcells. Previous inverted metamorphic quadruple-junction solar cells devices were constructed using two lattice-matched subcells and two lattice mismatched subcells. As a result, the cost of the epitaxy of the proposed architecture may be less expensive as the cell, e.g., may use a thinner top cell reducing In and P usage, may reduce the number of graded buffer layers to one from two, and may eliminate the need for a high In content bottom cell, which may be expensive due to the quantity of In required.

The basic concept of fabricating an inverted metamorphic multijunction (IMM) solar cell is to grow the subcells of the solar cell on a substrate in a "reverse" sequence. That is, the high band gap subcells (i.e. subcells with band gaps in the range of 1.9 to 2.3 eV), which would normally be the "top" subcells facing the solar radiation, are grown epitaxially on a semiconductor growth substrate, such as for example GaAs or Ge, and such subcells are therefore lattice-matched to such substrate. One or more lower band gap middle subcells (i.e. with band gaps in the range of 1.3 to 1.9 eV) can then be grown on the high band gap subcells.

At least one lower subcell is formed over the middle subcell such that the at least one lower subcell is substantially lattice-mismatched with respect to the growth substrate and such that the at least one lower subcell has a third lower band gap (e.g., a band gap in the range of 0.8 to 1.2 eV). A surrogate substrate or support structure is then attached or provided over the "bottom" or substantially lattice-mismatched lower subcell, and the growth semiconductor substrate is subsequently removed. (The growth substrate may then subsequently be re-used for the growth of a second and subsequent solar cells).

The present disclosure is directed to the fabrication of a four, five, or six junction inverted metamorphic solar cell using at least two different metamorphic layers, all grown on a single growth substrate. In the present disclosure, the resulting construction in one embodiment includes five subcells, with band gaps in the range of 1.92 to 2.2 eV (e.g., 2.10 eV), 1.65 to 1.78 eV (e.g., 1.73 eV), 1.42 to 1.50 eV (e.g., 1.42 eV), 1.05 to 1.15 eV (e.g., 1.10 eV), and 0.8 to 0.9 eV respectively.

The lattice constants and electrical properties of the layers in the semiconductor structure are preferably controlled by specification of appropriate reactor growth temperatures and times, and by use of appropriate chemical composition and dopants. The use of a vapor deposition method, such as Organo Metallic Vapor Phase Epitaxy (OMVPE), Metal Organic Chemical Vapor Deposition (MOCVD), Molecular Beam Epitaxy (MBE), or other vapor deposition methods for the reverse growth may enable the layers in the monolithic semiconductor structure forming the cell to be grown with the required thickness, elemental composition, dopant concentration and grading and conductivity type.

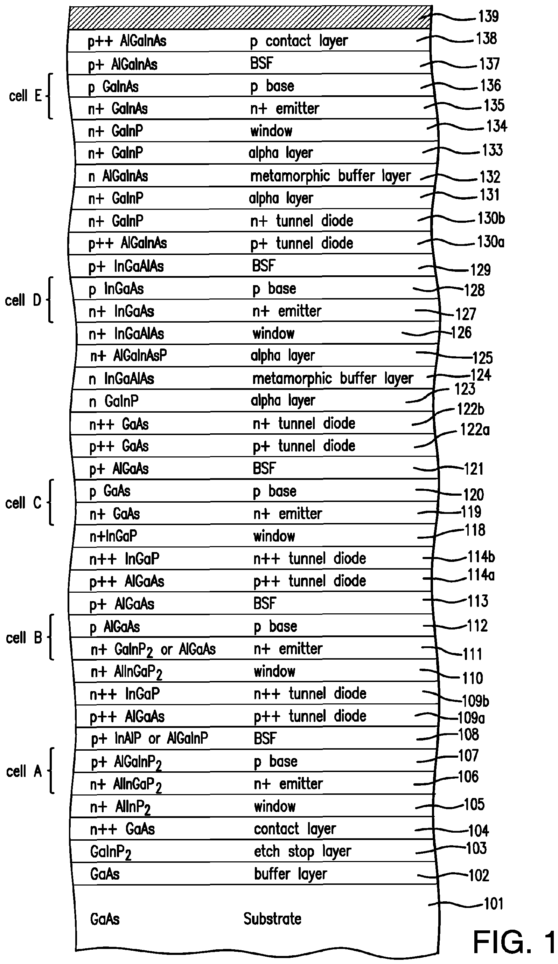

FIG. 1 depicts the multijunction solar cell according to the present disclosure after the sequential formation of the five subcells A, B, C, D and E on a GaAs growth substrate. More particularly, there is shown a growth substrate 101, which is preferably gallium arsenide (GaAs), but may also be germanium (Ge) or other suitable material. For GaAs, the substrate is preferably a 15º off-cut substrate, that is to say, its surface is orientated 15º off the (100) plane towards the (111)A plane, as more fully described in U.S. Patent Application Pub. No. 2009/0229662 A1 (Stan et al.).

In the case of a Ge substrate, a nucleation layer (not shown) is deposited directly on the substrate 101. On the substrate, or over the nucleation layer (in the case of a Ge substrate), a buffer layer 102 and an etch stop layer 103 are further deposited. In the case of GaAs substrate, the buffer layer 102 is preferably GaAs. In the case of Ge substrate, the buffer layer 102 is preferably InGaAs. A contact layer 104 of GaAs is then deposited on layer 103, and a window layer 105 of AlInP is deposited on the contact layer. The subcell A, consisting of an n+ emitter layer 106 and a p-type base layer 107, is then epitaxially deposited on the window layer 105. The subcell A is generally latticed matched to the growth substrate 101.

It should be noted that the multijunction solar cell structure could be formed by any suitable combination of group III to V elements listed in the periodic table subject to lattice constant and bandgap requirements, wherein the group III includes boron (B), aluminum (Al), gallium (Ga), indium (In), and thallium (T). The group IV includes carbon (C), silicon (Si), germanium (Ge), and tin (Sn). The group V includes nitrogen (N), phosphorous (P), arsenic (As), antimony (Sb), and bismuth (Bi).

In one embodiment, the emitter layer 106 is composed of InGa(Al)P₂ and the base layer 107 is composed of InGa(Al)P₂. The aluminum or Al term in parenthesis in the preceding formula means that Al is an optional constituent, and in this instance may be used in an amount ranging from 0% to 40%.

Subcell A will ultimately become the "top" subcell of the inverted metamorphic structure after completion of the process steps according to the present disclosure to be described hereinafter.

On top of the base layer 107 a back surface field ("BSF") layer 108 preferably p+ AlGaInP is deposited and used to reduce recombination loss.

The BSF layer 108 drives minority carriers from the region near the base/BSF interface surface to minimize the effect of recombination loss. In other words, a BSF layer 108 reduces recombination loss at the backside of the solar subcell A and thereby reduces the recombination in the base.

On top of the BSF layer 108 is deposited a sequence of heavily doped p-type and n-type layers 109a and 109b that forms a tunnel diode, i.e., an ohmic circuit element that connects subcell A to subcell B. Layer 109a is preferably composed of p++ AlGaAs, and layer 109b is preferably composed of n++ InGaP.

A window layer 110 is deposited on top of the tunnel diode layers 109a/109b, and is preferably n+ InGaP. The advantage of utilizing InGaP as the material constituent of the window layer 110 is that it has an index of refraction that closely matches the adjacent emitter layer 111, as more fully described in U.S. Patent Application Pub. No. 2009/0272430 A1 (Cornfeld et al.). The window layer 110 used in the subcell B also operates to reduce the interface recombination loss. It should be apparent to one skilled in the art, that additional layer(s) may be added or deleted in the cell structure without departing from the scope of the present disclosure.

On top of the window layer 110 the layers of subcell B are deposited: the n-type emitter layer 111 and the p-type base layer 112. These layers are preferably composed of InGaP and AlInGaAs respectively (for a Ge substrate or growth template), or InGaP and AIGaAs respectively (for a GaAs substrate), although any other suitable materials consistent with lattice constant and bandgap requirements may be used as well. Thus, subcell B may be composed of a GaAs, InGaP, AlGaInAs, AlGaAsSb, GaInAsP, or AlGaInAsP, emitter region and a GaAs, InGaP, AlGaInAs, AlGaAsSb, GaInAsP, or AlGaInAsP base region.

In previously disclosed implementations of an inverted metamorphic solar cell, the second subcell or subcell B or was a homostructure. In the present disclosure, similarly to the structure disclosed in U.S. Patent Application Pub. No. 2009/0078310 A1 (Stan et al.), the second subcell or subcell B becomes a heterostructure with an InGaP emitter and its window is converted from InAlP to AlInGaP. This modification reduces the refractive index discontinuity at the window/emitter interface of the second subcell, as more fully described in U.S. Patent Application Pub. No. 2009/0272430 A1 (Cornfeld et al.). Moreover, the window layer 110 is preferably is doped three times that of the emitter 111 to move the Fermi level up closer to the conduction band and therefore create band bending at the window/emitter interface which results in constraining the minority carriers to the emitter layer.

On top of the cell B is deposited a BSF layer 113 which performs the same function as the BSF layer 109. The p++/n++ tunnel diode layers 114a and 114b respectively are deposited over the BSF layer 113, similar to the layers 109a and 109b, forming an ohmic circuit element to connect subcell B to subcell C. The layer 114a is preferably composed of p++ AlGaAs, and layer 114b is preferably composed of n++ InGaP.

A window layer 118 preferably composed of n+ type GaInP is then deposited over the tunnel diode layer 114. This window layer operates to reduce the recombination loss in subcell "C". It should be apparent to one skilled in the art that additional layers may be added or deleted in the cell structure without departing from the scope of the present disclosure.

On top of the window layer 118, the layers of cell C are deposited: the n+ emitter layer 119, and the p-type base layer 120. These layers are preferably composed of n+ type GaAs and n+ type GaAs respectively, or n+ type InGaP and p type GaAs for a heterojunction subcell, although another suitable materials consistent with lattice constant and bandgap requirements may be used as well.

In some embodiments, subcell C may be (In)GaAs with a band gap between 1.40 eV and 1.42 eV. Grown in this manner, the cell has the same lattice constant as GaAs but has a low percentage of indium, i.e. 0% < In < 1%, to slightly lower the band gap of the subcell without causing it to relax and create dislocations. In this case, the subcell remains lattice matched, albeit strained, and has a lower band gap than GaAs. This helps improve the subcell short circuit current slightly and improve the efficiency of the overall solar cell.

In some embodiments, the third subcell or subcell C may have quantum wells or quantum dots that effectively lower the band gap of the subcell to approximately 1.3 eV. All other band gap ranges of the other subcells described above remain the same. In such embodiment, the third subcell is still lattice matched to the GaAs substrate. Quantum wells are typically "strain balanced" by incorporating lower band gap or larger lattice constant InGaAs (e.g. a band gap of ~1.3 eV) and higher band gap or smaller lattice constant GaAsP. The larger/smaller atomic lattices/layers of epitaxy balance the strain and keep the material lattice matched.

A BSF layer 121, preferably composed of InGaAlAs, is then deposited on top of the cell C, the BSF layer performing the same function as the BSF layers 108 and 113.

The p++/n++ tunnel diode layers 122a and 122b respectively are deposited over the BSF layer 121, similar to the layers 114a and 114b, forming an ohmic circuit element to connect subcell C to subcell D. The layer 122a is preferably composed of p++ GaAs, and layer 122b is preferably composed of n++ GaAs.

An alpha layer 123, preferably composed of n-type GaInP, is deposited over the tunnel diode 122a/122b, to a thickness of from 0.25 to 1.0 micron. Such an alpha layer is intended to prevent threading dislocations from propagating, either opposite to the direction of growth into the top and middle subcells A, B and C, or in the direction of growth into the subcell D, and is more particularly described in U.S. Patent Application Pub. No. 2009/0078309 A1 (Cornfeld et al.).

A metamorphic layer (or graded interlayer) 124 is deposited over the alpha layer 123 using a surfactant. Layer 124 is preferably a compositionally step-graded series of InGaAlAs layers, preferably with monotonically changing lattice constant, so as to achieve a gradual transition in lattice constant in the semiconductor structure from subcell C to subcell D while minimizing threading dislocations from occurring. The band gap of layer 124 is constant throughout its thickness, preferably approximately equal to 1.5 to 1.6 eV, or otherwise consistent with a value slightly greater than the band gap of the middle subcell C. One embodiment of the graded interlayer may also be expressed as being composed of (InₓGa₁₋ₓ)_{y} Al_{1-y}As, with 0 < x < 1, 0 < y < 1, and x and y selected such that the band gap of the interlayer remains constant at approximately 1.5 to 1.6 eV or other appropriate band gap.

In the surfactant assisted growth of the metamorphic layer 124, a suitable chemical element is introduced into the reactor during the growth of layer 124 to improve the surface characteristics of the layer. In the preferred embodiment, such element may be a dopant or donor atom such as selenium (Se) or tellurium (Te). Small amounts of Se or Te are therefore incorporated in the metamorphic layer 124, and remain in the finished solar cell. Although Se or Te are the preferred n-type dopant atoms, other non-isoelectronic surfactants may be used as well.

Surfactant assisted growth results in a much smoother or planarized surface. Since the surface topography affects the bulk properties of the semiconductor material as it grows and the layer becomes thicker, the use of the surfactants minimizes threading dislocations in the active regions, and therefore improves overall solar cell efficiency.

As an alternative to the use of non-isoelectronic one may use an isoelectronic surfactant. The term "isoelectronic" refers to surfactants such as antimony (Sb) or bismuth (Bi), since such elements have the same number of valence electrons as the P atom of InGaP, or the As atom in InGaAlAs, in the metamorphic buffer layer. Such Sb or Bi surfactants will not typically be incorporated into the metamorphic layer 124.

In the inverted metamorphic structure described in the Wanlass et al. paper cited above, the metamorphic layer consists of nine compositionally graded InGaP steps, with each step layer having a thickness of 0.25 micron. As a result, each layer of Wanlass et al. has a different bandgap. In one of the embodiments of the present disclosure, the layer 124 is composed of a plurality of layers of InGaAlAs, with monotonically changing lattice constant, each layer having the same band gap, approximately in the range of 1.5 to 1.6 eV.

The advantage of utilizing a constant bandgap material such as InGaAlAs is that arsenide-based semiconductor material is much easier to process in standard commercial MOCVD reactors, while the small amount of aluminum assures radiation transparency of the metamorphic layers.

Although the preferred embodiment of the present disclosure utilizes a plurality of layers of InGaAlAs for the metamorphic layer 124 for reasons of manufacturability and radiation transparency, other embodiments of the present disclosure may utilize different material systems to achieve a change in lattice constant from subcell C to subcell D. Other embodiments of the present disclosure may utilize continuously graded, as opposed to step graded, materials. More generally, the graded interlayer may be composed of any of the As, P, N, Sb based III - V compound semiconductors subject to the constraints of having the in-plane lattice parameter greater than or equal to that of the second solar cell and less than or equal to that of the third solar cell, and having a bandgap energy greater than that of the second solar cell.

An alpha layer 125, preferably composed of n+ type AlGaInAsP, is deposited over metamorphic buffer layer 124, to a thickness of from 0.25 to 1.0 micron. Such an alpha layer is intended to prevent threading dislocations from propagating, either opposite to the direction of growth into the top and middle subcells A, B and C, or in the direction of growth into the subcell D, and is more particularly described in U.S. Patent Application Pub. No. 2009/0078309 A1 (Cornfeld et al.).

A window layer 126 preferably composed of n+ type InGaAlAs is then deposited over alpha layer 125. This window layer operates to reduce the recombination loss in the fourth subcell "D". It should be apparent to one skilled in the art that additional layers may be added or deleted in the cell structure without departing from the scope of the present disclosure.

On top of the window layer 126, the layers of cell D are deposited: the n+ emitter layer 127, and the p-type base layer 128. These layers are preferably composed of n+ type InGaAs and p type InGaAs respectively, or n+ type InGaP and p type InGaAs for a heterojunction subcell, although another suitable materials consistent with lattice constant and bandgap requirements may be used as well.

A BSF layer 129, preferably composed of p+ type InGaAlAs, is then deposited on top of the cell D, the BSF layer performing the same function as the BSF layers 108, 113 and 121.

The p++/n++ tunnel diode layers 130a and 130b respectively are deposited over the BSF layer 129, similar to the layers 122a/122b and 109a/109b, forming an ohmic circuit element to connect subcell D to subcell E. The layer 130a is preferably composed of p++ AlGaInAs, and layer 130b is preferably composed of n++ GaInP.

In some embodiments an alpha layer 131, preferably composed of n-type GaInP, is deposited over the tunnel diode 130a/130b, to a thickness in the range of 0.25 to 1.0 micron, and in one embodiment about 0.5 micron. Such alpha layer is intended to prevent threading dislocations from propagating, either opposite to the direction of growth into the middle subcells C and D, or in the direction of growth into the subcell E, and is more particularly described in copending U.S. Patent Application Serial No. 11/860,183, filed September 24, 2007.

A second metamorphic layer (or graded interlayer) 132 is deposited over the barrier layer 131. Layer 132 is preferably a compositionally step-graded series of AlGaInAs layers, preferably with monotonically changing lattice constant, so as to achieve a gradual transition in lattice constant in the semiconductor structure from subcell D to subcell E while minimizing threading dislocations from occurring. In some embodiments the band gap of layer 132 is constant throughout its thickness, preferably approximately equal to [1.1 eV], or otherwise consistent with a value slightly greater than the band gap of the middle subcell D. One embodiment of the graded interlayer may also be expressed as being composed of (InₓGa₁₋ₓ)_{y} Al_{1-y}As, with 0 < x < 1, 0 < y < 1, and x and y selected such that the band gap of the interlayer remains constant at approximately [1.1 eV] or other appropriate band gap.

In one embodiment of the present disclosure, an optional second barrier layer 133 with a thickness in the range of 0.25 to 1.0 micron may be deposited over the AlGaInAs metamorphic layer 132. The second barrier layer 133 performs essentially the same function as the first barrier layer 131 of preventing threading dislocations from propagating. In one embodiment, barrier layer 133 does not have the same composition than that of barrier layer 131, i.e. n+ type GaInP.

A window layer 134 preferably composed of n+ type GaInP is then deposited over the barrier layer 133. This window layer operates to reduce the recombination loss in the fifth subcell "E". It should be apparent to one skilled in the art that additional layers may be added or deleted in the cell structure without departing from the scope of the present invention.

On top of the window layer 134, the layers of cell E are deposited: the n+ emitter layer 135, and the p-type base layer 136. These layers are preferably composed of n+ type GaInAs and p type GaInAs respectively, although other suitable materials consistent with lattice constant and band gap requirements may be used as well.

A BSF layer 137, preferably composed of p+ type AlGaInAs, is then deposited on top of the cell E, the BSF layer performing the same function as the BSF layers 108, 113, 121, and 129.

Finally a high band gap contact layer 138, preferably composed of p++ type AlGaInAs, is deposited on the BSF layer 137.

The composition of this contact layer 138 located at the bottom (non-illuminated) side of the lowest band gap photovoltaic cell (i.e., subcell "E" in the depicted embodiment) in a multijunction photovoltaic cell, can be formulated to reduce absorption of the light that passes through the cell, so that (i) the backside ohmic metal contact layer below it (on the non-illuminated side) will also act as a mirror layer, and (ii) the contact layer doesn't have to be selectively etched off, to prevent absorption.

It should be apparent to one skilled in the art, that additional layer(s) such as a sixth subcell "F" may be added in the cell structure without departing from the scope of the present invention.

A metal contact layer 139 is deposited over the p semiconductor contact layer 138. The metal is the sequence of metal layers Ti/Au/Ag/Au in some embodiments.

The metal contact scheme chosen is one that has a planar interface with the semiconductor, after heat treatment to activate the ohmic contact. This is done so that (1) a dielectric layer separating the metal from the semiconductor doesn't have to be deposited and selectively etched in the metal contact areas; and (2) the contact layer is specularly reflective over the wavelength range of interest.

Optionally, an adhesive layer (e.g., Wafer Bond, manufactured by Brewer Science, Inc. of Rolla, MO) can be deposited over the metal layer 131, and a surrogate substrate can be attached. In some embodiments, the surrogate substrate may be sapphire. In other embodiments, the surrogate substrate may be glass, GaAs, Ge or Si, or other suitable material. The surrogate substrate can be about 40 mils in thickness, and can be perforated with holes about 1 mm in diameter, spaced 4 mm apart, to aid in subsequent removal of the adhesive and the substrate. As an alternative to using an adhesive layer, a suitable substrate (e.g., GaAs) may be eutectically or permanently bonded to the metal layer 131.

Optionally, the original substrate can be removed by a sequence of lapping and/or etching steps in which the substrate 101, and the buffer layer 102 are removed. The choice of a particular etchant is growth substrate dependent.

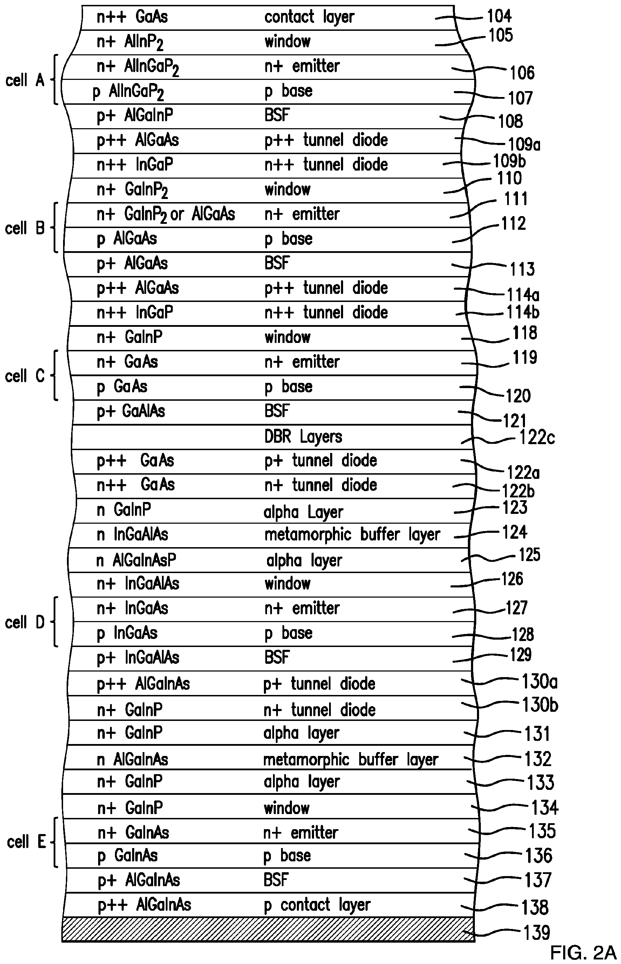

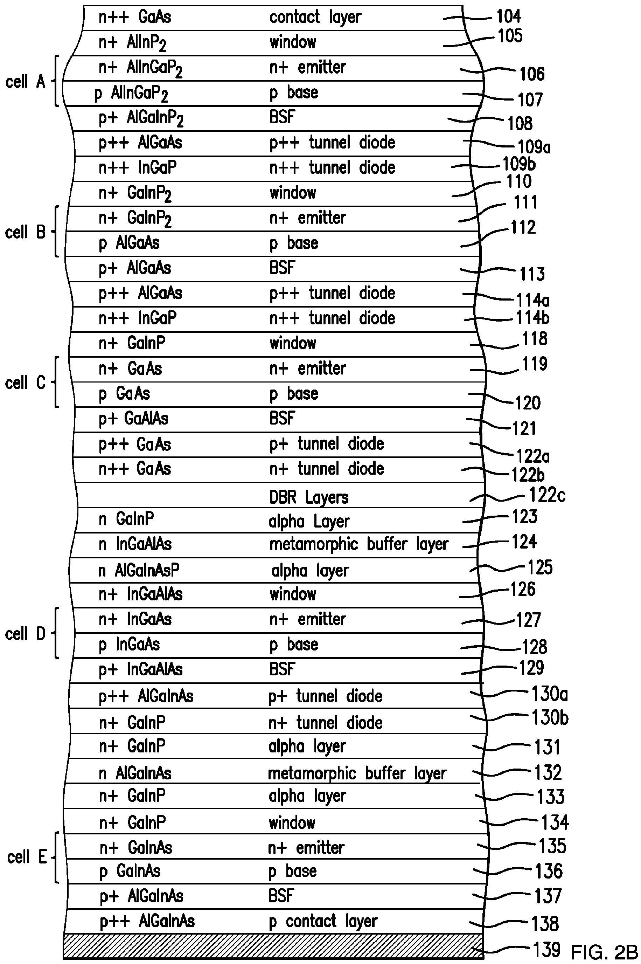

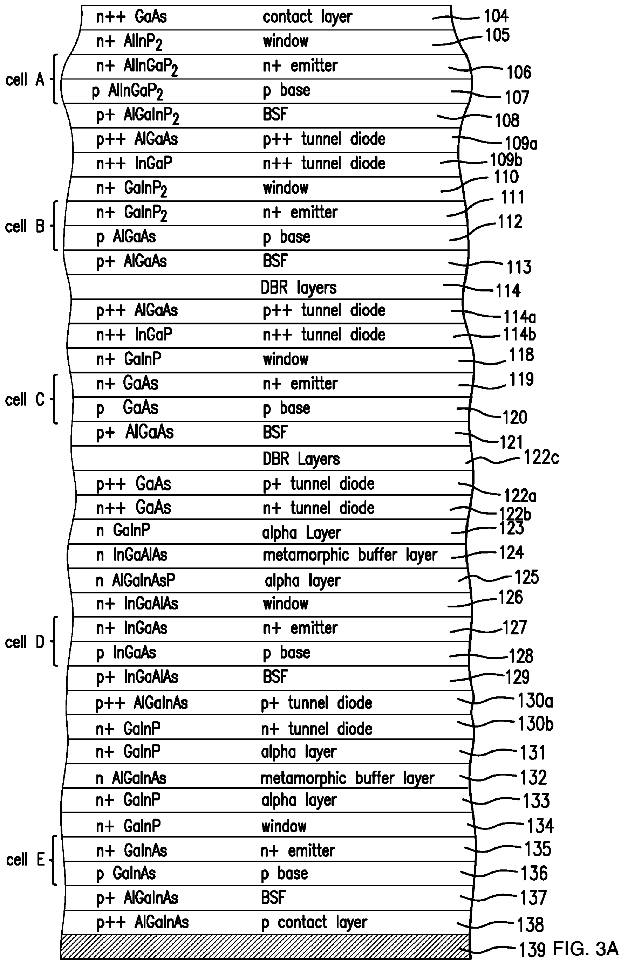

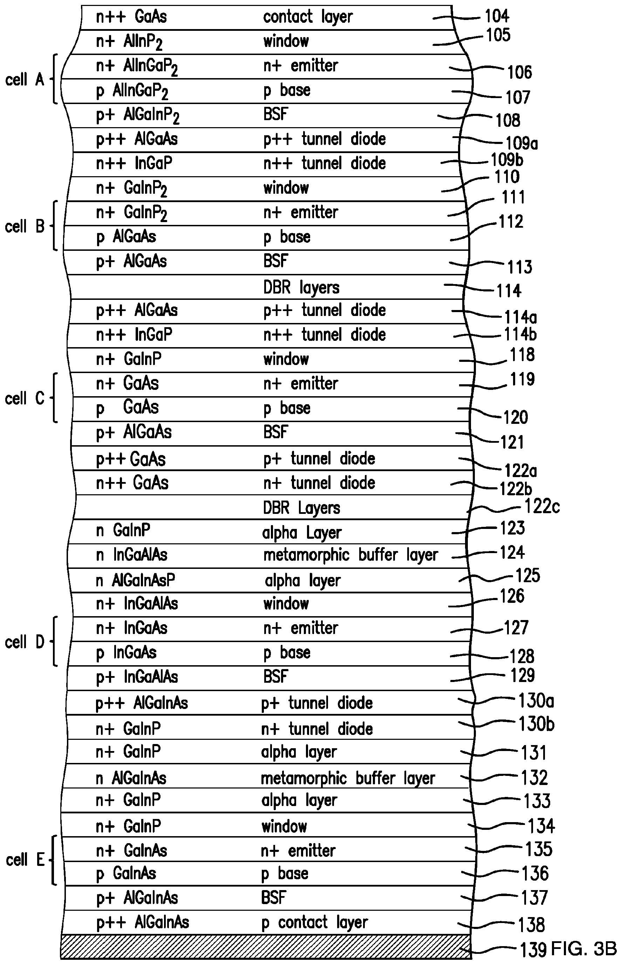

Figures 2A, 2B, 3A, and 3B are cross-sectional views of embodiments of solar cells similar to that in FIG. 1, with the orientation with the metal contact layer 131 being at the bottom of the Figure and with the original substrate having been removed. In addition, the etch stop layer 103 has been removed, for example, by using a HCl/H₂O solution.

It should be apparent to one skilled in the art, that additional layer(s) may be added or deleted in the cell structure without departing from the scope of the present disclosure. For example, one or more distributed Bragg reflector (DBR) layers can be added for various embodiments of the present invention.

Figures 2A and 2B are cross-sectional views of embodiments of a solar cell similar to that of FIG. 1 that includes distributed Bragg reflector (DBR) layers 122c.

FIG. 2A is a cross-sectional view of a first embodiment of a solar cell similar to that of FIG. 1 that includes distributed Bragg reflector (DBR) layers 122c adjacent to and between the third solar subcell C and the graded interlayer 124 and arranged so that light can enter and pass through the third solar subcell C and at least a portion of which can be reflected back into the third solar subcell C by the DBR layers 122c. In FIG. 2A, the distributed Bragg reflector (DBR) layers 122c are specifically located between the third solar subcell C and tunnel diode layers 122a/122b.

FIG. 2B is a cross-sectional view of a second embodiment of a solar cell similar to that of FIG. 1 that includes distributed Bragg reflector (DBR) layers 122c adjacent to and between the third solar subcell C and the graded interlayer 124 and arranged so that light can enter and pass through the third solar subcell C and at least a portion of which can be reflected back into the third solar subcell C by the DBR layers 122c. In FIG. 2B, the distributed Bragg reflector (DBR) layers 122c are specifically located between tunnel diode layers 122a/122b and graded interlayer 124.

Figures 3A and 3B are cross-sectional views of embodiments of a solar cell similar to that of FIG. 1 that include distributed Bragg reflector (DBR) layers 114 in addition to the distributed Bragg reflector layers 122c described in Figures 2A and 2B.

FIG. 3A is a cross-sectional view of a first embodiment of a solar cell similar to that of FIG. 1 that includes, in addition to the distributed Bragg reflector layers 122c described in Figures 2A and 2B, distributed Bragg reflector (DBR) layers 114 adjacent to and between the second solar subcell B and the third solar subcell C and arranged so that light can enter and pass through the second solar subcell B and at least a portion of which can be reflected back into the second solar subcell B by the DBR layers 114. In FIG. 3A, the distributed Bragg reflector (DBR) layers 114 are specifically located between the second solar subcell and tunnel diode layers 114a/114b; and the distributed Bragg reflector (DBR) layers 122c are specifically located between the third solar subcell C and tunnel diode layers 122a/122b.

FIG. 3B is a cross-sectional view of a second embodiment of a solar cell similar to that of FIG. 1 that includes , in addition to the distributed Bragg reflector layers 122c described in Figures 2A and 2B, distributed Bragg reflector (DBR) layers 114 adjacent to and between the second solar subcell B and the third solar subcell C and arranged so that light can enter and pass through the second solar subcell B and at least a portion of which can be reflected back into the second solar subcell B by the DBR layers 114. In FIG. 3B, the distributed Bragg reflector (DBR) layers 114 are specifically located between the second solar subcell and tunnel diode layers 114a/114b; and the distributed Bragg reflector (DBR) layers 122c are specifically located between tunnel diode layers 122a/122b and graded interlayer 124.

Some implementations provide that at least the base of at least one of the first, second or third solar subcells has a graded doping, i.e., the level of doping varies from one surface to the other throughout the thickness of the base layer. In some embodiments, the gradation in doping is exponential. In some embodiments, the gradation in doping is incremental and monotonic.

In some embodiments, the emitter of at least one of the first, second or third solar subcells also has a graded doping, i.e., the level of doping varies from one surface to the other throughout the thickness of the emitter layer. In some embodiments, the gradation in doping is linear or monotonically decreasing.

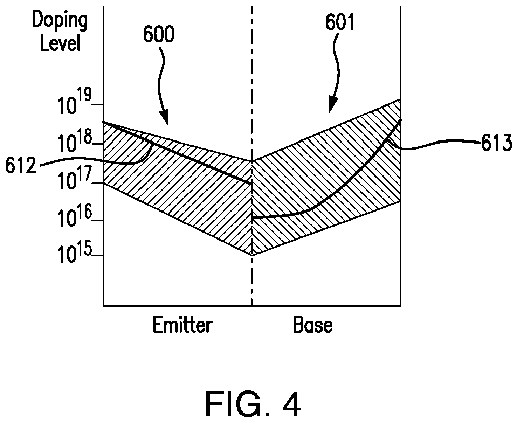

As a specific example, the doping profile of the emitter and base layers may be illustrated in Figure 4, which depicts the amount of doping in the emitter region and the base region of a subcell. N-type dopants include silicon, selenium, sulfur, germanium or tin. P-type dopants include silicon, zinc, chromium, or germanium.

In the example of Figure 4, in some embodiments, one or more of the subcells have a base region having a gradation in doping that increases from a value in the range of 1 x 10¹⁵ to 1 x 10¹⁸ free carriers per cubic centimeter adjacent the p-n junction to a value in the range of 1 x 10¹⁶ to 4 x 10¹⁸ free carriers per cubic centimeter adjacent to the adjoining layer at the rear of the base, and an emitter region having a gradation in doping that decreases from a value in the range of approximately 5 x 10¹⁸ to 1 x 10¹⁷ free carriers per cubic centimeter in the region immediately adjacent the adjoining layer to a value in the range of 5 x 10¹⁵ to 1 x 10¹⁸ free carriers per cubic centimeter in the region adjacent to the p-n junction.

For some embodiments, distributed Bragg reflector (DBR) layers 114 and/or 122c can be composed of a plurality of alternating layers of lattice matched materials with discontinuities in their respective indices of refraction. For certain embodiments, the difference in refractive indices between alternating layers is maximized in order to minimize the number of periods required to achieve a given reflectivity, and the thickness and refractive index of each period determines the stop band and its limiting wavelength.

For some embodiments, distributed Bragg reflector (DBR) layers 114 and/or 122c includes a first DBR layer composed of a plurality of p type AlₓGa₁₋ₓAs layers, and a second DBR layer disposed over the first DBR layer and composed of a plurality of p type Al_{y}Ga_{1-y}As layers, where y is greater than x, and 0 < x < 1, 0 < y < 1.

In a first embodiment of the present invention, an intrinsic layer constituted by a strain-balanced multi-quantum well structure 501 is formed between base layer 410b and emitter layer 411 of middle subcell C. The strain-balanced quantum well structure 501 includes a sequence of quantum well layers formed from alternating layers of compressively strained InGaAs and tensionally strained gallium arsenide phosphide ("GaAsP"). Strain-balanced quantum well structures are known from the paper of Chao-Gang Lou et al., Current-Enhanced Quantum Well Solar Cells, Chinese Physics Letters, Vol. 23, No.1 (2006), and M. Mazzer et al., Progress in Quantum Well Solar Cells, Thin Solid Films, Volumes 511-512 (26 July 2006).

In an alternative example, the strain-balanced quantum well structure 501, comprising compressively strained InGaAs and tensionally strained gallium arsenide, may be provided as either the base layer 410b or the emitter layer 411.

In the illustrated example, the strain-balanced quantum well structure 501 is formed in the depletion region of the middle subcell C and has a total thickness of about 3 microns (mm). Different thicknesses may be used as well. Alternatively, the middle subcell C can incorporate the strain-balanced quantum well structure 501 as either the base layer 410 or the emitter layer 411 without an intervening layer between the base layer 410 and emitter layer 411. A strain-balanced quantum well structure can include one or more quantum wells. As shown in the example of FIG. 3C, the quantum wells may be formed from alternating layers of compressively strained InGaAs and tensionally strained GaAsP. An individual quantum well within the structure includes a well layer of InGaAs provided between two barrier layers of GaAsP, each having a wider energy band gap than InGaAs. The InGaAs layer is compressively strained due to its larger lattice constant with respect to the lattice constant of the substrate 400. The GaAsP layer is tensionally strained due to its smaller lattice constant with respect to the substrate 400. The "strain-balanced" condition occurs when the average strain of the quantum well structure is approximately equal to zero. Strain-balancing ensures that there is almost no stress in the quantum well structure when the multijunction solar cell layers are grown epitaxially. The absence of stress between layers can help prevent the formation of dislocations in the crystal structure, which would otherwise negatively affect device performance. For example, the compressively strained InGaAs well layers of the quantum well structure 323 may be strain-balanced by the tensile strained GaAsP barrier layers.

The quantum well structure 500 may also be lattice matched to the substrate 400. In other words, the quantum well structure may possess an average lattice constant that is approximately equal to a lattice constant of the substrate 400. In other embodiments, lattice matching the quantum well structure 500 to the substrate 400 may further reduce the formation of dislocations and improve device performance. Alternatively, the average lattice constant of the quantum well structure 500 may be designed so that it maintains the lattice constant of the parent material in the middle subcell C. For example, the quantum well structure 500 may be fabricated to have an average lattice constant that maintains the lattice constant of the AIGaAs BSF layer 410a. In this way, dislocations are not introduced relative to the middle cell C. However, the overall device 600 is lattice mismatched if the lattice constant of the middle cell C is not matched to the substrate 400. The thickness and composition of each individual InGaAs or GaAsP layer within the quantum well structure 500 may be adjusted to achieve strain-balance and minimize the formation of crystal dislocations. For example, the InGaAs and GaAsP layers may be formed having respective thicknesses about 100-300 angstroms (D). Between 100 and 300 total InGaAs/GaAsP quantum wells may be formed in the strain-balanced quantum well structure 500. More or fewer quantum wells may be used as well. Additionally, the concentration of indium in the InGaAs layers may vary between 10-30%.

Furthermore, the quantum well structure 501 can extend the range of wavelengths absorbed by the middle subcell C. An example of approximate quantum efficiency curves for the multijunction solar cell of FIG. 3C is illustrated in FIG. 7A. As shown in the example of FIG. 7A, the absorption spectrum for the bottom subcell 305 extends between 890-1600 nm; the absorption spectrum of the middle subcell 307 extends between 660-1000 nm, overlapping the absorption spectrum of the bottom subcell; and the absorption spectrum of the top subcell A extends between 300-660 nm. Incident photons having wavelengths located within the overlapping portion of the middle and bottom subcell absorption spectrums may be absorbed by the middle subcell 307 prior to reaching the bottom subcell D. As a result, the photocurrent produced by middle subcell 307 may increase by taking some of the current that would otherwise be excess current in the bottom subcell 304. In other words, the photo-generated current density produced by the middle subcell 307 may increase. Depending on the total number of layers and thickness of each layer within the quantum well structure 323, the photo-generated current density of the middle subcell 307 may be increased to match the photo-generated current density of the bottom subcell 305.

The overall current produced by the multijunction cell solar cell then may be raised by increasing the current produced by top subcell 309. Additional current can be produced by top subcell 309 by increasing the thickness of the p-type InGaP2 base layer 332 in that cell. The increase in thickness allows additional photons to be absorbed, which results in additional current generation. Preferably, for space or AM0 applications, the increase in thickness of the top subcell 309 maintains the approximately 4 to 5% difference in current generation between the top subcell A and middle subcell C. For AM1 or terrestrial applications, the current generation of the top cell and the middle cell may choose to be mated.

As a result, both the introduction of strain-balanced quantum wells in the middle subcell 307 and the increase in thickness of top subcell A provide an increase in overall multijunction solar cell current generation and enable an improvement in overall photon conversion efficiency. Furthermore, the increase in current may be achieved without significantly reducing the voltage across the multijunction solar cell.

In some embodiments, the sequence of first 501A and second 501 B different semiconductor layers forms the base layer of the second subcell.

In some embodiments, the sequence of first and second different semiconductor layers comprises compressively strained and tensionally strained layers, respectively.

In some embodiments, an average strain of the sequence of first and second different semiconductor layers is approximately equal to zero.

In some embodiments, each of the first and second semiconductor layers is approximately 100 nm to 300 angstroms thick.

In some embodiments, the first semiconductor layer comprises InGaAs and the second semiconductor layer comprises GaAsP.

In some embodiments, a percentage of indium in each InGaAs layer is in the range of 10 to 30%.

In some embodiments, the top subcell comprises InGaP and has a thickness so that it generates approximately 4-5% less current than said first current.

In some embodiments, at least the base of at least one of the first A, second B or third C solar subcells has a graded doping, i.e., the level of doping varies from one surface to the other throughout the thickness of the base layer. In some embodiments, the gradation in doping is exponential. In some embodiments, the gradation in doping is incremental and monotonic.

In some embodiments, the emitter of at least one of the first A, second B or third C solar subcells also has a graded doping, i.e., the level of doping varies from one surface to the other throughout the thickness of the emitter layer. In some embodiments, the gradation in doping is linear or monotonically decreasing.

As a specific example, the doping profile of the emitter and base layers may be illustrated in Figure 4, which depicts the amount of doping in the emitter region and the base region of a subcell. N-type dopants include silicon, selenium, sulfur, germanium or tin. P-type dopants include silicon, zinc, chromium, or germanium.

In the example of Figure 4, the emitter doping decreases from anywhere in the range of approximately 5 x 10¹⁸ to 1 x 10¹⁷ free carriers per cubic centimeter in the region immediately adjacent the adjoining layer to anywhere in the range of 1 x 10¹⁸ to 1 x 10¹⁵ free carriers per cubic centimeter in the region adjacent to the p-n junction which is shown by the dotted line in the referenced Figure.

The base doping increases from anywhere in the range of 1 x 10¹⁵ to 1 x 10¹⁸ free carriers per cubic centimeter adjacent the p-n junction to anywhere in the range of 1 x 10¹⁶ to 1 x 10¹⁹ free carriers per cubic centimeter adjacent to the adjoining layer at the rear of the base.

In some embodiments, the doping level throughout the thickness of the base layer may be exponentially graded from the range of 1 x 10¹⁶ free carriers per cubic centimeter to 1 x 10¹⁸ free carriers per cubic centimeter, as represented by the curve 603 depicted in the Figure.

In some embodiments, the doping level throughout the thickness of the emitter layer may decline linearly from 5 x 10¹⁸ free carriers per cubic centimeter to 5 x 10¹⁷ free carriers per cubic centimeter as represented by the curve 602 depicted in the Figure.

The absolute value of the collection field generated by an exponential doping gradient exp [-x/λ] is given by the constant electric field of magnitude E = kT/q(1/λ))(exp[-*x_{b}*/λ]), where k is the Boltzman constant, T is the absolute temperature in degrees Kelvin, q is the absolute value of electronic change, and λ is a parameter characteristic of the doping decay.

The efficacy of an embodiment of the present disclosure has been demonstrated in a test solar cell which incorporated an exponential doping profile in the three micron thick base layer of a subcell, according to one embodiment of the present disclosure. Following measurements of the electrical parameters of the test cell, there was observed a 6.7% increase in current collection. The measurements indicated an open circuit voltage (V_{oc}) equal to at least 3.014 volts, a short circuit current density (J_{sc}) of at least 16.55 mA/cm², and a fill factor (FF) of at least 0.86 at AM0 for a triple junction solar cell.

The exponential doping profile taught by the present disclosure produces a constant field in the doped region. In the particular multijunction solar cell materials and structure of the present disclosure, the least radiation resistant subcell will have the lowest short circuit current among all the subcells. Since in a multijunction solar cell, the individual subcells are stacked and form a series circuit, the total current flow in the entire solar cell is therefore limited by the smallest current produced in any of the subcells. Thus, by increasing the short circuit current in the bottom cell, the current more closely approximates that of the higher subcells, and the overall efficiency of the solar cell is increased by 3% as well. In a multijunction solar cell with approximately 32% efficiency, the implementation of the present doping arrangement would increase efficiency by a factor of 1, i.e. to 3%. Such an increase in overall efficiency is substantial in the field of solar cell technology. In addition to an increase in efficiency, the collection field created by the exponential doping profile will enhance the radiation hardness of the solar cell, which is important for spacecraft applications.

Although the exponentially doped profile is the doping design which has been implemented and verified, other doping profiles may give rise to a linear varying collection field which may offer yet other advantages. For example, a doping profile of 1x10¹⁶ to 1x10¹⁸ produces a linear field in the doped region which would be advantageous for both minority carrier collection and for radiation hardness at the end-of-life (EOL) of the solar cell. Such other doping profiles in one or more base layers are within the scope of the present disclosure.

The doping profile depicted herein are merely illustrative, and other more complex profiles may be utilized as would be apparent to those skilled in the art without departing from the scope of the present invention.

The present disclosure provides an inverted metamorphic multijunction solar cell that follows a design rule that one should incorporate as many high bandgap subcells as possible to achieve the goal to increase high temperature EOL performance. For example, high bandgap subcells may retain a greater percentage of cell voltage as temperature increases, thereby offering lower power loss as temperature increases. As a result, both HT-BOL and HT-EOL performance of the exemplary inverted metamorphic multijunction solar cell may be expected to be greater than traditional cells.

The open circuit voltage (V_{oc}) of a compound semiconductor subcell loses approximately 2 mV per degree C as the temperature rises, so the design rule taught by the present disclosure takes advantage of the fact that a higher band gap (and therefore higher voltage) subcell loses a lower percentage of its V_{oc} with temperature. For example, a subcell that produces a 1.50 volts at 28°C produces 1.50 - 42*(0.0023) = 1.403 volts at 70°C which is a 6.4% voltage loss. A cell that produces 0.25 volts at 28°C produces 0.25 - 42*(0.0018) = 0.174 volts at 70° which is a 30.2% voltage loss.

In view of different satellite and space vehicle requirements in terms of temperature, radiation exposure, and operation life, a range of subcell designs using the design principles of the present disclosure may be provided satisfying typical customer and mission requirements, and several embodiments are set forth hereunder, along with the computation of their efficiency at the end-of-life. The radiation exposure is experimentally measured using 1 MeV electron fluence per square centimeter (abbreviated in the text that follows as e/cm²), so that a comparison can be made between the current commercial devices and embodiments of solar cells discussed in the present disclosure.

As an example, a low earth orbit (LEO) satellite will typically experience radiation equivalent to 5 x 10¹⁴ e/cm² over a five year lifetime. A geosynchronous earth orbit (GEO) satellite will typically experience radiation in the range of 5 x 10¹⁴ e/cm² to 1 x 10 e/cm² over a fifteen year lifetime.

For example, the cell efficiency (%) measured at room temperature (RT) 28° C and high temperature (HT) 70°C, at beginning of life (BOL) and end of life (EOL), for a standard three junction commercial solar cell (ZTJ) is as follows:

| **Condition** | **Efficiency** | |
|---|---|---|
| BOL 28°C | 29.1% | |
| BOL 70°C | 26.4% | |
| | | |
| EOL 70°C | 23.4% | After 5E14 e/cm² radiation |
| EOL 70°C | 22.0% | After 1 E15 e/cm² radiation |

For the four junction IMMX solar cell described in the parent application, the corresponding data is as follows:

| **Condition** | **Efficiency** | |
|---|---|---|
| BOL 28°C | 29.5% | |
| BOL 70°C | 26.6% | |
| EOL 70°C | 24.7% | After 5E14 e/cm² radiation |
| EOL 70°C | 24.2% | After 1 E15 e/cm² radiation |

One should note the slightly higher cell efficiency of the IMMX solar cell than the standard commercial solar cell (ZTJ) at BOL both at 28° C and 70° C. However, the IMMX solar cell described above exhibits substantially improved cell efficiency (%) over the standard commercial solar cell (ZTJ) at 1 MeV electron equivalent fluence of 5 x 10¹⁴ e/cm², and dramatically improved cell efficiency (%) over the standard commercial solar cell (ZTJ) at 1 MeV electron equivalent fluence of 1 x 10¹⁵ e/cm².

For the five junction IMMX solar cell described in the present application, the corresponding data is as follows:

| **Condition** | **Efficiency** | |
|---|---|---|
| BOL 28°C | 32.1% | |
| BOL 70°C | 30.4% | |
| | | |
| EOL 70°C | 27.1% | After 5E14 e/cm² radiation |
| EOL 70°C | 25.8% | After 1 E15 e/cm² radiation |

In some embodiments, the solar cell according to the present disclosure is also applicable to low intensity (LI) and/or low temperature (LT) environments, such as might be experienced in space vehicle missions to Mars, Jupiter, and beyond. A "low intensity" environment refers to a light intensity being less than 0.1 suns, and a "low temperature" environment refers to temperatures being in the range of less than minus 100 degrees Centigrade.

For such applications, depending upon the specific intensity and temperature ranges of interest, the band gaps of the subcells may be adjusted or "tuned" to maximize the solar cell efficiency, or otherwise optimize performance (e.g. at EOL or over the operational working life period).

The wide range of electron and proton energies present in the space environment necessitates a method of describing the effects of various types of radiation in terms of a radiation environment which can be produced under laboratory conditions. The methods for estimating solar cell degradation in space are based on the techniques described by Brown et al. [Brown, W. L., J. D. Gabbe, and W. Rosenzweig, Results of the Telstar Radiation Experiments, Bell System Technical J., 42, 1505, 1963] and Tada [Tada, H. Y., J.R. Carter, Jr., B.E. Anspaugh, and R. G. Downing, Solar Cell Radiation Handbook, Third Edition, JPL Publication 82-69, 1982]. In summary, the omnidirectional space radiation is converted to a damage equivalent unidirectional fluence at a normalised energy and in terms of a specific radiation particle. This equivalent fluence will produce the same damage as that produced by omnidirectional space radiation considered when the relative damage coefficient (RDC) is properly defined to allow the conversion. The relative damage coefficients (RDCs) of a particular solar cell structure are measured a priori under many energy and fluence levels in addition to different coverglass thickness values. When the equivalent fluence is determined for a given space environment, the parameter degradation can be evaluated in the laboratory by irradiating the solar cell with the calculated fluence level of unidirectional normally incident flux. The equivalent fluence is normally expressed in terms of 1 MeV electrons or 10 MeV protons.

The software package Spenvis (www.spenvis.oma.be) is used to calculate the specific electron and proton fluence that a solar cell is exposed to during a specific satellite mission as defined by the duration, altitude, azimuth, etc. Spenvis employs the EQFLUX program, developed by the Jet Propulsion Laboratory (JPL) to calculate 1 MeV and 10 MeV damage equivalent electron and proton fluences, respectively, for exposure to the fluences predicted by the trapped radiation and solar proton models for a specified mission environment duration. The conversion to damage equivalent fluences is based on the relative damage coefficients determined for multijunction cells [Marvin, D.C., Assessment of Multijunction Solar Cell Performance in Radiation Environments, Aerospace Report No. TOR-2000 (1210)-1, 2000]. New cell structures eventually need new RDC measurements as different materials can be more or less damage resistant than materials used in conventional solar cells. A widely accepted total mission equivalent fluence for a geosynchronous satellite mission of 15 year duration is 1 MeV 1x10¹⁵ electrons/cm².

The exemplary solar cell described herein may require the use of aluminum in the semiconductor composition of each of the top two or three subcells. Aluminum incorporation is widely known in the III-V compound semiconductor industry to degrade BOL subcell performance due to deep level donor defects, higher doping compensation, shorter minority carrier lifetimes, and lower cell voltage and an increased BOL E_{g}/q - V_{oc} metric. In short, increased BOL E_{g}/q - V_{oc} may be the most problematic shortcoming of aluminum containing subcells; the other limitations can be mitigated by modifying the doping schedule or thinning base thicknesses.

Furthermore, at BOL, it is widely accepted that great subcells have a room temperature E_{g}/q - V_{oc} of approximately 0.40. A wide variation in BOL E_{g}/q - V_{oc} may exist for subcells of interest to IMMX cells. However, Applicants have found that inspecting E_{g}/q - V_{oc} at HT-EOL may reveal that aluminum containing subcells perform no worse than other materials used in III-V solar cells. For example, all of the subcells at EOL, regardless of aluminum concentration or degree of lattice-mismatch, have been shown to display a nearly-fixed E_{g}/q - V_{oc} of approximately 0.6 at room temperature 28°C.

The exemplary inverted metamorphic multijunction solar cell design philosophy may be described as opposing conventional cell efficiency improvement paths that employ infrared subcells that increase in expense as the bandgap of the materials decreases. For example, proper current matching among all subcells that span the entire solar spectrum is often a normal design goal. Further, known approaches - including dilute nitrides grown by MBE, upright metamorphic, and inverted metamorphic multijunction solar cell designs - may add significant cost to the cell and only marginally improve HT-EOL performance. Still further, lower HT-EOL $/W may be achieved when inexpensive high bandgap subcells are incorporated into the cell architecture, rather than more expensive infrared subcells. The key to enabling the exemplary solar cell design philosophy described herein is the observation that aluminum containing subcells perform well at HT-EOL.

Without further analysis, the foregoing will so fully reveal the gist of the present disclosure that others can, by applying current knowledge, readily adapt it for various applications without omitting features that, from the standpoint of prior art, fairly constitute essential characteristics of the generic or specific aspects of this disclosure and, therefore, such adaptations should and are intended to be comprehended within the meaning and range of equivalence of the following claims.

## Claims

1. A multijunction solar cell comprising:
an upper first solar subcell having a first band gap in the range of 1.92 to 2.2 eV;
a second solar subcell adjacent to said first solar subcell and having a second band gap in the range of 1.65 to 1.78 eV;
a third solar subcell adjacent to said second solar subcell and having a third band gap in the range of 1.40 to 1.50 eV;
a first graded interlayer adjacent to said third solar subcell; said first graded interlayer having a fourth band gap greater than said third band gap; and
a fourth solar subcell adjacent to said first graded interlayer, said fourth subcell having a fifth band gap in the range of 1.05 to 1.15 eV such that said fourth subcell is lattice mismatched with respect to said third subcell;
a second graded interlayer adjacent to said fourth solar subcell; said second graded interlayer having a sixth band gap greater than said fifth band gap; and
a lower fifth solar subcell adjacent to said second graded interlayer, said lower fifth subcell having a seventh band gap in the range of 0.8 to 0.9 eV such that said fourth subcell is lattice mismatched with respect to said fourth subcell,
wherein the first graded interlayer is compositionally graded to lattice match the third solar subcell on one side and the lower fourth solar subcell on the other side, and is composed of (InₓGa₁₋ₓ)_{y}Al_{1-y}As with 0 < x < 1, 0 < y < 1, and x and y selected such that the band gap remains at a constant value in the range of 1.42 to 1.60 eV throughout its thickness; and
wherein the second graded interlayer is compositionally graded to lattice match the fourth solar subcell on one side and the lower fifth solar subcell on the other side, and is composed of (InₓGa₁₋ₓ)_{y}Al_{1-y}As with 0 < x < 1, 0 < y < 1, and x and y selected such that the band gap remains at a constant value in the range of 1.2 eV to 1.6 eV throughout its thickness.

2. The multijunction solar cell as defined in claim 1, wherein the lower fifth solar subcell has a band gap in the range of approximately 0.83 to 0.85 eV, the fourth solar subcell has a band gap of approximately 1.10 eV, the third solar subcell has a band gap in the range of 1.40 to 1.42 eV, the second solar subcell has a band gap of approximately 1.73 eV and the upper first solar subcell has a band gap of approximately 2.10 eV.

3. The multijunction solar cell as defined in any of claims 1-2, further comprising a sixth solar subcell disposed between the first solar subcell and the lower fifth solar subcell.

4. The multijunction solar cell as defined in any of claims 1-3, wherein each subcell includes an emitter region and a base region, and one or more of the subcells have a base region having a gradation in doping that increases exponentially from 1 x 10¹⁵ free carriers per cubic centimeter adjacent the p-n junction to 4 x 10¹⁸ free carriers per cubic centimeter adjacent to the adjoining layer at the rear of the base, and an emitter region having a gradation in doping that decreases from approximately 5 x 10¹⁸ free carriers per cubic centimeter in the region immediately adjacent the adjoining layer to 5 x 10¹⁷ free carriers per cubic centimeter in the region adjacent to the p-n junction.

5. The multijunction solar cell as defined in any of claims 1-4, wherein the upper first solar subcell is composed of AlGaInP, the second solar subcell is composed of an InGaP emitter layer and a AIGaAs base layer, the third solar subcell is composed of GaAs, and the fourth and fifth solar subcells are composed of InGaAs.

6. The multijunction solar cell as defined in any of claims 1-5, further comprising:
a distributed Bragg reflector (DBR) layer adjacent to and between the second and the third solar subcells and arranged so that light can enter and pass through the second solar subcell and at least a portion of which can be reflected back into the second solar subcell by the DBR layer.

7. The multijunction solar cell as defined in any of claim 1-6, further comprising:
a distributed Bragg reflector (DBR) layer adjacent to and between the third solar subcell and the first graded interlayer and arranged so that light can enter and pass through the third solar subcell and at least a portion of which can be reflected back into the third solar subcell by the DBR layer;
wherein the distributed Bragg reflector layer is composed of a plurality of alternating layers of lattice matched materials with discontinuities in their respective indices of refraction and wherein the difference in refractive indices between alternating layers is maximized in order to minimize the number of periods required to achieve a given reflectivity, and the thickness and refractive index of each period determines the stop band and its limiting wavelength;
wherein the DBR layer includes a first DBR layer composed of a plurality of p type AlₓGa₁₋ₓAs layers, 0 < x < 1 and a second DBR layer disposed over the first DBR layer and composed of a plurality of p type Al_{y}Ga_{1-y}As layers, 0 < y < 1 and where y is greater than x.

8. The multijunction solar cell as defined in any of claims 1-7, wherein the amount of aluminum in the upper first subcell, and the second and third subcells, is between 10% and 40% by mole fraction.

9. The multijunction solar cell as defined in any of claims 1-8, wherein the solar cell efficiency (%) measured at room temperature (RT) 28°C and high temperature (HT) 70°C are as follows: (i) at BOL 28°C the solar cell has at least 32.1% efficiency; (ii) at BOL 70°C the solar cell has at least 30.4% efficiency; (iii) at EOL at 70°C the solar cell has at least 27.1% efficiency after 5E14 e/cm² radiation; and (iv) at EOL 70°C the solar cell has at least 25.8% efficiency after 1 E15 e/cm² radiation.

10. A method of manufacturing a solar cell comprising:
providing a first substrate;
depositing on the first substrate a first sequence of layers of semiconductor material forming a first solar subcell, a second solar subcell, and a third solar subcell;
depositing on said third solar subcell a first grading interlayer;
depositing on said first grading interlayer a second sequence of layers of semiconductor material forming a fourth solar subcell, the fourth solar subcell being lattice mismatched to the third solar subcell;
depositing on said fourth solar subcell a second grading interlayer;
depositing on said second grading interlayer a third sequence of layers of semiconductor material forming a fifth solar subcell, the fifth solar subcell being lattice mismatched to the third solar subcell;
mounting and bonding a surrogate substrate on top of the sequence of layers; and
removing the first substrate;
wherein the first graded interlayer is compositionally graded to lattice matched the third solar subcell on one side and the lower fourth solar subcell on the other side, and is composed of the As, P, N, Sb based III-V compound semiconductors subject to the constraints of having the in-plane lattice parameter greater than or equal to that of the third solar subcell and less than or equal to that of the lower fourth solar subcell, and having a band gap energy greater than that of the third solar subcell and the fourth solar subcell;
wherein the second graded interlayer is compositionally graded to lattice match the fourth solar subcell on one side and the lower fifth solar subcell on the other side, and is composed of any of the As, P, N, Sb based III-V compound semiconductors subject to the constraints of having the in-plane lattice parameter greater than or equal to that of the fourth solar subcell and less than or equal to that of the lower fifth solar subcell, and having a band gap energy greater than that of the fourth solar subcell; and
wherein the fifth solar subcell has a band gap in the range of 0.8 to 0.9 eV, the fourth solar subcell has a band gap in the range of approximately 1.05 to 1.15 eV, the third solar subcell has a band gap in the range of approximately 1.40 to 1.50 eV, the second solar subcell has a band gap in the range of approximately 1.65 to 1.78 eV and the first solar subcell has a band gap in the range of 1.92 to 2.2 eV, and wherein its thickness, and the band gap of the first graded interlayer is in the range of 1.42 to 1.60 eV throughout its thickness, and the band gap of the second graded interlayer is in the range of 1.20 to 1.40 eV throughout its thickness.

11. The method as defined in claim 10, wherein the first solar subcell is composed of AlGaInP, the second solar subcell is composed of an InGaP emitter layer and a AIGaAs base layer, the third solar subcell is composed of GaAs or InₓGa₁₋ₓAs (with 0 < x < .01), and the fourth solar subcell is composed of InGaAs, and the fifth solar subcell is composed of GaInAs.

12. The method as defined in any of claims 10-11, wherein the third solar subcell includes quantum wells or quantum dots so that the band gap of the third solar subcell is approximately 1.3 eV.
